Europäisches Patentamt

(19) European Patent Office

Office européen des brevets

(11) Numéro de publication: **0 061 409**
**B1**

(12) # FASCICULE DE BREVET EUROPEEN

(45) Date de publication du fascicule du brevet:
05.12.84

(21) Numéro de dépôt: **82400541.7**

(22) Date de dépôt: **25.03.82**

(51) Int. Cl.³: **B 60 J  1/17,** E 05 F  15/00,
H 03 K  17/955

(54) **Vitre coulissante, mue électriquement, et munie d'un détecteur de sécurité.**

(30) Priorité: **25.03.81  DE 3111696**

(43) Date de publication de la demande:
**29.09.82 Bulletin 82/39**

(45) Mention de la délivrance du brevet:
**05.12.84 Bulletin 84/49**

(84) Etats contractants désignés:
**BE DE FR GB IT SE**

(56) Documents cités:
**DE - A - 1 690 298
DE - A - 2 939 942
FR - A - 2 073 975
US - A - 3 651 389**

(73) Titulaire: **SAINT-GOBAIN VITRAGE, Les
Miroirs 18, avenue d'Alsace, F-92400 Courbevoie (FR)**
(84) Etats contractants désignés: **BE FR GB IT SE**

(73) Titulaire: **VEGLA Vereinigte Glaswerke GmbH, Viktoria
Allee 3-5, D-5100 Aachen (DE)**
(84) Etats contractants désignés: **DE**

(72) Inventeur: **Sauer, Gerd, Heinrich Hamacher Weg 11,
D-5120 Stolberg-Venwegen (DE)**
Inventeur: **Unbehaun, Dieter, Kobergerstrasse 58,
D-8500 Nuernberg (DE)**

(74) Mandataire: **Breton, Jean-Claude et al, SAINT-GOBAIN
RECHERCHE 39, quai Lucien Lefranc,
F-93300 Aubervilliers Cedex (FR)**

## Description

L'invention a pour objet une vitre destinée à une fenêtre coulissante mue électriquement, en particulier sur des véhicules automobiles, et munie d'un dispositif de sécurité. Cette vitre comprend un détecteur de proximité formé d'une bande conductrice disposée le long de son bord supérieur pour constituer un capteur capacitif inséré dans l'étage de détection, à oscillateur, d'un circuit de commande électronique afin de couper l'alimentation électrique du moteur sous l'influence de la modification de capacité provoquée par la proximité entre le capteur et une partie du corps au-delà d'un certain seuil d'amortissement de l'oscillateur.

Des fenêtres coulissantes d'automobiles équipées de tels dispositif de sécurité ont été décrites dans le brevet US 3 651 389 et dans la demande de brevet allemande intercalaire 2 939 942 (& EP-A-26 719).

La bande conductrice comprend un tronçon qui sert de capteur à proprement parler et qui est placé dans la zone supérieure de la vitre, sur le chant étroit de cette dernière et, toujours sur ce chant, un tronçon servant de ligne de liaison vers le circuit électronique le long du bord vertical ou oblique rejoignant la zone inférieure de la vitre où se trouve le point de raccordement du câble qui relie le capteur à l'étage de détection.

Ces dispositifs de sécurité doivent répondre même lorsque le capteur n'entre pas directement en contact conducteur avec le corps, ce qui se produit par exemple lorsque l'on touche le bord du vitrage avec un gant. Pour que le seuil se trouve atteint même dans un tel cas, le circuit doit posséder une haute sensibilité. Mais le danger est alors grand que des causes diverses, autres que les amortissements de l'oscillateur dus à l'approche d'une partie du corps ne conduisent à dépasser ce seuil.

Les vitres connues, dont les bandes conductrices sont disposées sur le chant, ont plusieurs inconvénients. En premier lieu elles ne peuvent pas être fabriquées en série par les procédés classiques connus et exigeraient la mise au point de procédés nouveaux; d'autre part il s'est révélé que le fonctionnement des vitrages obtenus est relativement sensible aux influences parasites.

L'invention a donc pour objet de créer à cet usage une structure de vitre équipée d'une bande détectrice, qui d'une part puisse être fabriquée sans inconvénient appréciable pour sa sensibilité par des procédés appropriés à la fabrication en série et avec des dispositifs classiques et qui d'autre part soit moins sensible aux influences parasites lorsque le vitrage possède une sensibilité élevée au contact ou à l'approche d'une partie du corps.

Selon l'invention, la bande électriquement conductrice est placée sur la face interne de la vitre, sa section qui court le long du bord supérieur pour servir de capteur atteignant pratiquement l'arête du vitrage, tandis que celle qui sert de ligne de liaison vers le point de raccordement au circuit de commande électronique court le long d'un bord sensiblement vertical, à une distance de celui-ci suffisante pour réduire largement l'influence pertubatrice de l'encadrement de la fenêtre sur cette ligne de liaison, des lignes et des plages de contact ou de connexion servant à établir des commutations auxiliaires étant disposées dans la zone qui la sépare du bord en question.

En soi, il faut partir de ce que le déplacement du capteur du chant du vitrage vers une face principale de la vitre abaisse fortement la sensibilité de sorte que, pour ramener celle-ci à la valeur nécessaire il faut utiliser en compensation un circuit de détection électronique plus sensible: c'est une voie que l'on avait jusqu'ici considérée comme impraticable car l'augmentation de sensibilité se répercute aussi sur les influences parasites. Le décalage de la ligne de liaison verticale du bord du vitrage vers le centre de la fenêtre également prévu par l'invention compense toutefois en partie cet effet gênant de l'augmentation de sensibilité; en effet, on s'est aperçu qu'une grande partie des influences capacitives gênantes apparaissaient précisément sur ce tronçon de bande conductrice. C'est pourquoi, en fin de compte, il s'est avéré que sur une vitre construite conformément à l'invention, il devenait possible de réduire les difficultés observées jusqu'à un niveau qui permît de les vaincre.

La caractéristique complémentaire de l'invention selon laquelle les lignes de commutation sont placées dans le domaine compris entre la ligne de liaison et le bord de la vitre contribue aussi à réduire les perturbations et à augmenter la sécurité de fonctionnement. Ces lignes permettent, en effet, de commuter les circuits lorsque la vitre atteint des positions déterminées, d'une part pour couper l'alimentation du moteur aux fins de course d'ouverture et de fermeture et d'autre part dans certaines positions intermédiaires, par exemple lors de la phase finale de fermeture, peu avant que le bord supérieur de la vitre ne pénètre dans le cadre de la fenêtre, pour modifier la sensibilité du circuit de détection ce qui élimine ou du moins réduit les perturbations résultant du fait que le capteur s'approche du cadre métallique.

La vitre selon l'invention a d'autre part pour avantage de pouvoir porter les lignes conductrices ou plages auxiliaires destinées aux usages les plus divers, lesquelles seront constituées du même matériau que le capteur et déposées en même temps que celui-ci. De telles lignes et plages auxiliaires peuvent servir, par exemple, à constituer un réseau de chauffage, des alimentations de courant, un détecteur d'humidité, une antenne ou à souder des connexions.

D'autres caractéristiques et développements avantageux de l'invention ressortent de la description suivante d'exemples de mise en oeuvre représentés par les dessins. Ces dessins montrent:

figure 1 une vue d'ensemble de la forme la plus simple d'une vitre d'automobile conforme à l'invention;

figure 2 une vitre d'automobile conforme à l'invention munie en outre d'un réseau chauffant avec capteur d'humidité et de plages de connexion;

figure 3 une coupe selon la ligne III.III de la figure 1;

figure 4 une coupe analogue à celle de la figure 3, toutefois selon une variante dans laquelle les bandes conductrices sont revêtues d'une couche protectrice;

figure 5 un détail du bord latéral d'un autre vitrage conforme à l'invention;

figure 6 une coupe selon la ligne VI.VI de la figure 5;

figure 7 une nouvelle variante de vitrage conforme à l'invention, munie de lignes conductrices recouvertes d'une couche protectrice;

figure 8 une autre variante, dont le détecteur a la forme d'une boucle fermée.

Les vitres représentées par les figures sont destinées à des fenêtres coulissantes de portes de voitures automobiles. De telles vitres peuvent avoir des formes très différentes, mais, en règle générale, elles ressemblent à là vitre 1, rectangulaire avec un bord abattu 2 correspondant à la forme de l'ouverture de la fenêtre. Le bord inférieur 3 est pris dans un profilé métallique non représenté sur lequel le moteur, qui n'est pas non plus représenté, agit par l'intermédiaire d'une transmission convenable à levier, à arbre....

Le long du bord supérieur horizontal 4 et du bord oblique 2 se trouve placé sur la face interne du vitrage, c'est-à-dire celle tournée vers l'intérieur de l'habitacle, un conducteur électrique disposé sous forme d'une bande conductrice d'une largeur de l'ordre de 0,4 à 1 mm et d'une épaisseur de l'ordre de 0,01 à 0,02 mm, qui constitue le capteur 5.

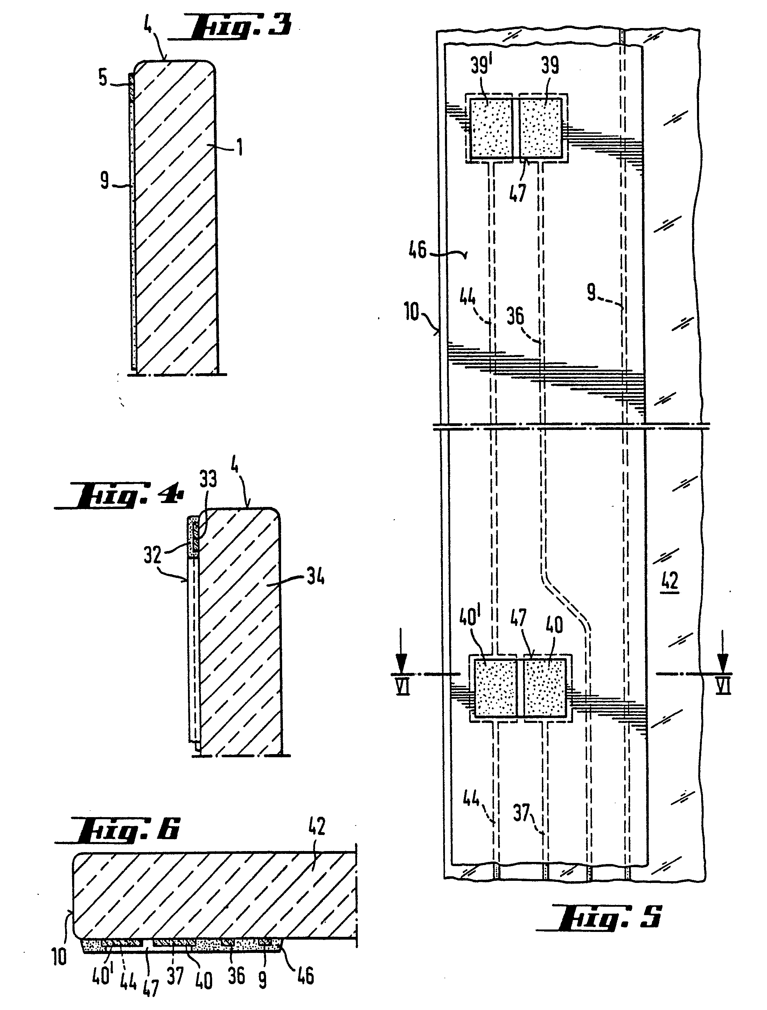

Comme le montre plus particulièrement la figure 3, il est placé au voisinage immédiat de l'arête c'est-à-dire à une distance de celle-ci de 1 à 5 mm. Il s'agit d'une bande imprimée, normalement constituée d'un émail à chaud à base d'argent métallique sous forme d'une pâte céramique pour sérigraphie du commerce, couramment utilisée pour la fabrication de vitrages chauffants d'automobiles. Le dépôt s'effectue de façon connue à l'écran de soie et les bandes obtenues sont cuites à une température de l'ordre de 600°C, de préférence au cours du traitement thermique nécessaire tant pour le bombage que pour la trempe du volume.

Le circuit de détection et de commande électronique comprenant un oscillateur plus ou moins amorti par le jeu du capteur se trouve à l'intérieur du caisson de la portière, par exemple, au voisinage du moteur d'entraînement de la vitre ou, avantageusement, posé directement sur cette dernière au voisinage de son bord inférieur 3. Le raccordement électrique du capteur 5 au circuit de détection et de commande se fait sur la plage de contact élargie 8, constituée du même émail à chaud que le capteur 5 et déposée en même temps que lui. Le capteur 5 lui-même est relié à cette plage par l'intermédiaire de la ligne de liaison 9, toujours constituée du même matériau, déposée et cuite en même temps.

La ligne 9 se trouve à une distance A d'au moins 2 cm environ du bord plus ou moins vertical 10 de la feuille de verre. L'éloignement ainsi créé entre elle et le cadre métallique de la fenêtre garantit qu'il n'y aura pas d'amortissement parasite de l'oscillateur sous l'influence du rapprochement et du couplage accru entre ces deux éléments au fur et à mesure que le fenêtre se ferme.

Dans la zone de la vitre délimitée par le bord 10 et la ligne de liaison 9 sont disposées deux lignes de commutation 12 et 13 qui débouchent à une extrémité sur des plages de contact 14 et 15 et à l'autre extrémité sur des plages de connexion 16 et 17. Les plages de contact 14 et 15 coopérent avec des contacts glissants placés dans le cadre de la fenêtre pour couper l'alimentation du moteur d'entraînement dans les deux positions de fin de course de la vitre.

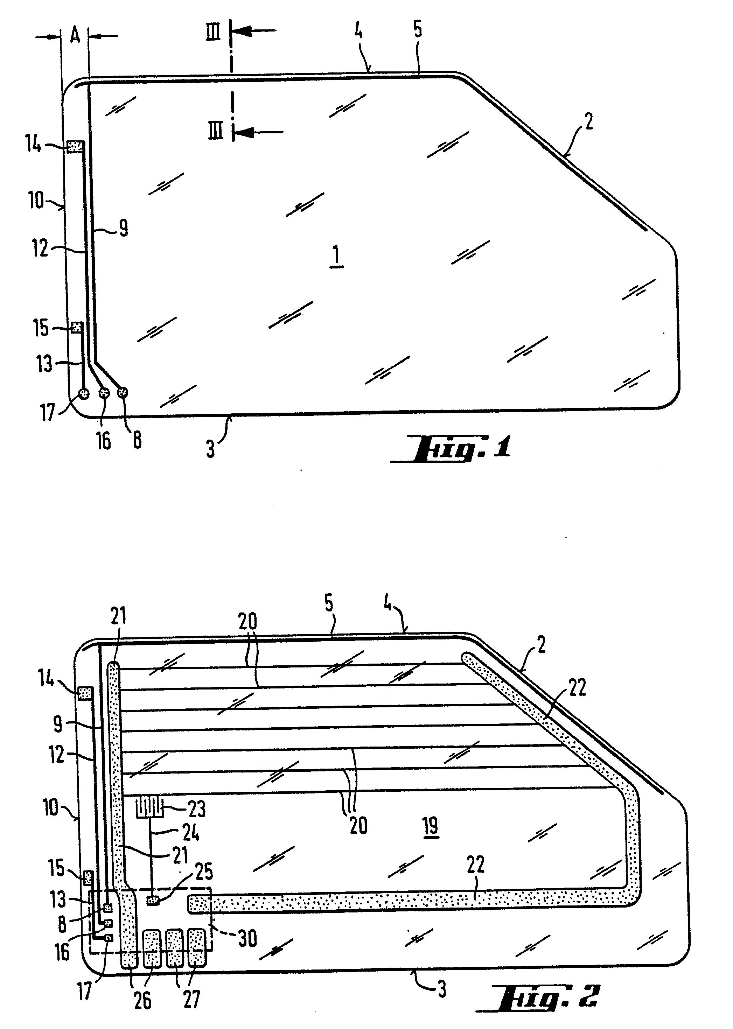

La vitre 19 représentée sur la figure 2 présente la même disposition de conducteurs que celle de la figure 1 mais elle est en outre équipée de conducteurs électriques chauffants 20 raccordés à leurs extrémité sur des collecteurs latéraux 21 et 22, et sa surface porte un détecteur d'humidité 23 relié par l'intermédiaire d'une ligne de commande 24 à une plage de connexion 25. D'autres plages de connexion 26 et 27 sont encore disposées sur la surface du verre. Les plages de connexion 26 servent au raccordement sur le réseau d'alimentation du véhicule et les plages de connexion 27 au raccordement du moteur d'entraînement de la fenêtre.

Toutes ces bandes conductrices et plages de contact ou de connexion sont déposées sur le verre en même temps que le capteur 5 et là ligne de liaison 9 et constituées du même émail céramique cuit à chaud.

Dans la version représentée sur la figure 2, le circuit de détection et de commande est formé d'un élément compact représenté en lignes tiretées, en particulier d'un circuit intégré monolithique 30 fixé directement, par exemple collé solidement et durablement à même la surface du verre. Les lignes 9 et 24, et le cas échéant 12 et 13, sensibles aux couplages parasites, se trouvent ainsi dans une disposition fixe entre elles et par rapport au circuit de détection ce qui non seulement simplifie le raccordement à ce circuit mais surtout élimine, dans une large mesure, les risques de perturbations.

Dans de nombreux cas on peut souhaiter recouvrir en tout ou en partie les bandes conductrices à l'aide d'une couche isolante pour les protéger des contacts directs. On peut alors déposer sur les bandes conductrices imprimées et séchées, au cours d'une deuxième opération d'impression, une composition céramique isolante, puis cuire l'ensemble des couches en une seule fois. La figure 4 représente une telle couche de protection 32 déposée sur un conducteur 33 porté par la face interne d'une vitre 34. Il est clair que pour ne pas détruire leurs qualités respectives, il faut alors utiliser des compositions céramiques compatibles; on en trouve dans le commerce, en particulier en pâtes applicables par le procédé classique à l'écran de soie, tout à fait approprié à l'opération.

Sur la marge de la vitre, entre la ligne de liaison 9 et le bord 10 peuvent être déposées d'autres lignes, de commutation, qui permettent par exemple de modifier progressivement la sensibilité du circuit de détection, ce qui est notamment utile au cours de la montée de la vitre lorsque celle-ci se rapproche de sa position de fermeture. Un amortissement de l'oscillateur susceptible de provoquer l'arrêt du moteur se produit en effet au fur et à mesure que le capteur se rapproche du cadre métallique, ce que la modification progressive de sensibilité qui vient d'être décrite permet d'éviter. De telles dispositions sont représentées par les figures 5 à 8.

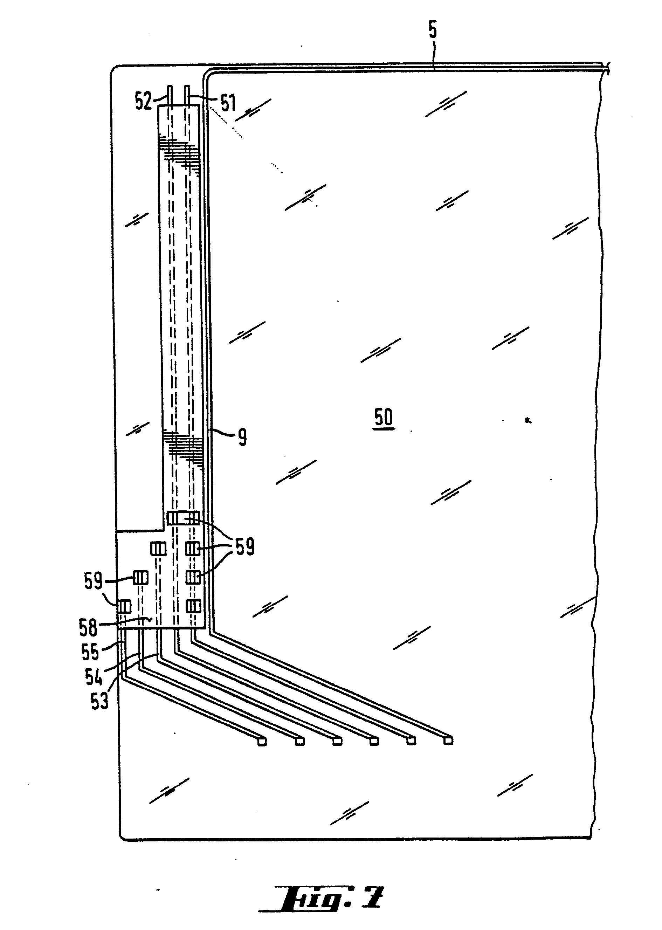

Dans la version des figures 5 et 6, deux lignes de commutation 36, 37 aboutissant à des plages de contact 39, 40 sont disposées entre le bord 10 du vitrage 42 et la ligne de liaison 9. En regard des plages de contact 39 et 40 sont placées des plages de contact 39' et 40' raccordées à une même ligne d'alimentation 44 de sorte qu'un ou des contacts glissants disposés à emplacements fixes dans le cadre de la fenêtre permettront au passage de fermer un circuit pour provoquer les commutations désirées dans les positions correspondantes du vitrage. Les lignes conductrices sont recouvertes d'une couche protectrice électriquement isolante 46, constituée d'un émail à chaud, dans laquelle des fenêtres 47 sont ménagées à l'emplacement des plages de contact 39 et 40 pour laisser libres ces dernières, de sorte que les contacts glissants n'établissent le contact électrique que sur les plages en question. La couche protectrice 46 est encore déposée à l'écran de soie à partir d'une pâte céramique sur les lignes conductrices, aussitôt que ces dernières, imprimées au préalable, sont sèches. La fusion et la cuisson des lignes et de la couche protectrice s'effectuent en une seule étape au cours du traitement qui permet de tremper thermiquement la feuille de verre.

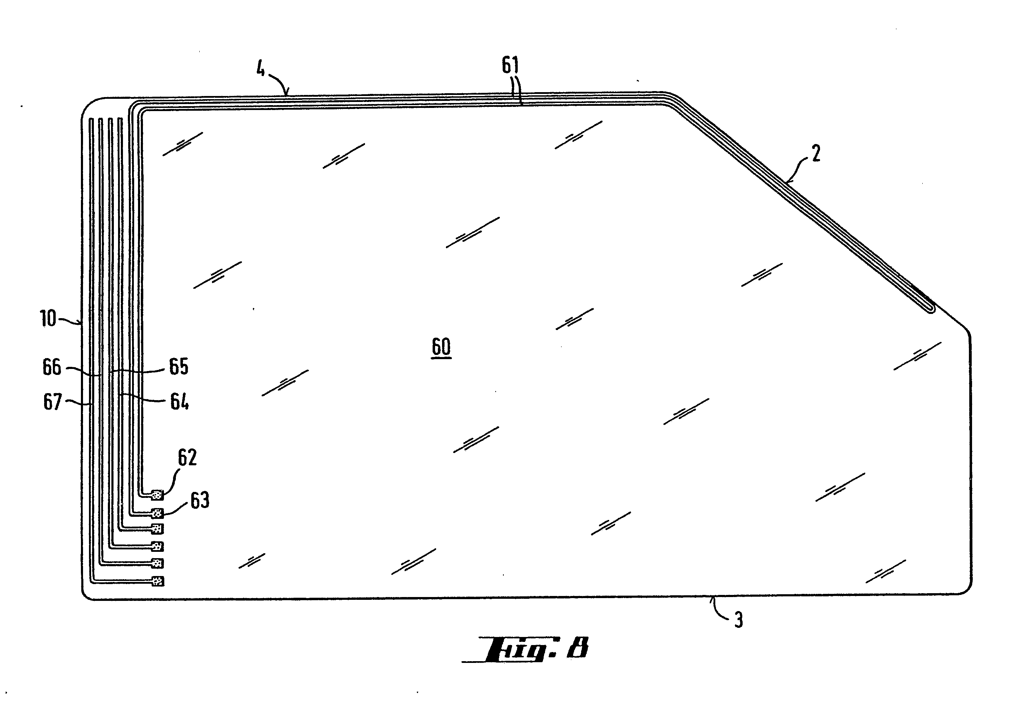

Dans la version représentée par la figure 7, la vitre 50 porte, à côté de la ligne de liaison 9, un ensemble de cinq lignes de commutation 51 à 55 protégées par une même couche isolante 58 d'un émail constitué comme précédemment d'une pâte céramique cuite à chaud. Des fenêtres 59 sont pratiquées à diverses hauteurs dans la couche protectrice 58 pour libérer les lignes de commutation aux emplacements désirés de sorte qu'un contact glissant disposé dans le cadre de la fenêtre relie successivement les lignes 52, 53, 54 et 55 à la ligne 51. La ligne de commutation 52 sert à couper le moteur en fin de course d'ouverture. Lors de la fermeture, la commutation successive des lignes 53 et 54 modifie par étapes successives la sensibilité du circuit dans la phase finale, c'est-à-dire peu avant la pénétration du bord supérieur de la vitre dans le cadre; enfin en position extrême, le moteur est coupé par liaison des lignes de commutation 55 et 51.

On peut obtenir une autre amélioration du circuit de commande en donnant au capteur déposé sur la vitre 60 la forme d'une boucle 61 fermée en épingle double comme le motre la figure 8, et qui aboutit aux deux plages de connexion 62, 63 raccordées au circuit de détection. Cette forme d'exécution permet de vérifier en permanence, par l'intermédiaire du circuit de détection, si le capteur est actif sur toute sa longueur; en même temps, il devient possible d'utiliser la boucle comme système d'alarme en faisant que son interruption par suite de la destruction du vitrage déclenche un signal tel qu'une sirène.

Quatre lignes de commutation 64 à 67 sont en outre disposées dans la marge latérale pour remplir les fonctions décrites dans le cadre des figures précédentes. Des lignes de commutation comme la boucle conductrice 61 sont avantageusement recouvertes d'une couche protectrice non représentée sur la figure.

## Revendications

1. Vitre (1) de fenêtre coulissante mûe électriquement comprenant un détecteur de proximité (5) disposé le long de son bord supérieur (4, 2) sous forme d'une bande conductrice pour constituer un capteur capacitif inséré dans l'étage de détection, à oscillateur, d'un circuit de commande électronique coupant l'alimentation électrique du moteur au-delà d'un certain seuil d'amortissement, caractérisée en ce que ladite bande conductrice est placée sur la face interne de la vitre, sa section qui court le long du bord supérieur pour servir de capteur (5, 33) atteignant pratiquement l'arête (4, 2) du vitrage tandis que celle qui sert de ligne de liaison (9) vers le point de raccordement (8) au circuit de commande électronique court le long d'un bord sensiblement vertical (10) mais à distance de celui-ci, des lignes de commutation et des plages de contact (12, 13; 36, 37; 44; 51 à 55; 64 à 67) étant disposées dans la zone qui la sépare du bord en question.

2. Vitre selon la revendication 1, caractérisée en ce que le détecteur de proximité (5, 33), la ligne de liaison (9), les lignes de commutation (12, 13; 36, 37; 44; 51 à 55; 64 à 67) et leurs plages de contact ou de connexion (8) sont constitués d'un émail à chaud électriquement conducteur disposé sous forme d'une pâte céramique à l'écran de soie et cuit en une seule fois, à une température de l'ordre de 600°C.

3. Vitre selon l'une des revendications 1 et 2, caractérisée en ce que le détecteur de proximité a la forme d'une boucle fermée en épingle double (61).

4. Vitre selon l'une des revendications 2 et 3, caractérisée en ce que les bandes électriquement conductrices sont recouvertes d'une couche protectrice isolante (32, 46, 68) d'un émail à chaud compatible avec le premier.

5. Vitre selon l'une des revendications 1 à 4, caractérisée par un circuit de détection constitué d'un élément compact (30) posé à même sa surface.

## Claims

1. A pane (1) for an electrically operated sliding window comprising a proximity detector (5) arranged along its upper edge (4, 2) in the form of a conducting strip to forma capacitive detector inserted in an oscillator detection stage, an electronic control circuit cutting off electric feed to the motor above a certain level of damping, characterised in that said conducting strip is placed on the interior surface of the pane, its part which runs along the upper edge to serve as a detector (5, 33) reaching pratically the extreme edge (4, 2) of the pane whereas that part which serves as a connecting line (9) towards the point of connection (8) to the electronic control circuit runs along an edge which is substantially vertical (10) but at a distance from the latter, switching lines and contact areas (12, 13; 36, 37; 44; 51 to 55; 64 to 67) being arranged in the zone which separates it from the edge in question.

2. Pane according to claim 1, characterised in that the proximity detector (5, 33), the connection line (9) the switch lines (12, 13; 36, 37; 44; 51 to 55; 64 to 67) and their areas for contact or connection (8) are formed of a electrically conducting fired enamel provided in the form of a ceramic paste applied by silkscreen printing and fired a single time at a temperature of the order of 600°C.

3. Pane according to one of claims 1 and 2, characterised in that the proximity detector has the shape of a closed loop which is doubled (61).

4. Pane according to one of claims 2 and 3, characterised in that the conducting electric strips are covered with an insulating protective layer (32, 46, 68) of fired enamel compatible with the first.

5. Pane according to one of claims 1 to 4, characterised by a detection circuit formed of a compact element (30) positioned on the surface.

**Patentansprüche**

1. Glasscheibe (1) für ein elektrisch angetriebenes versenkbares Fenster mit einem entlang ihrer oberen Kante (4, 2) angeordneten Annäherungsfühler (5) in Form eines Leitstreifens, der als kapazitiver Fühler einen Teil einer einen Oszillator umfassenden Detektionsstufe eines elektronischen Schaltkreises bildet, der oberhalb eines bestimmten Dämpfungs-Schwellwertes die Stromzufuhr zu dem Elektromotor unterbricht, dadurch gekennzeichnet, dass der Leitstreifen auf der inneren Oberfläche der Glasscheibe angeordnet ist, dass der entlang der oberen Kante angeordnete als Fühler (5, 33) dienende Abschnitt praktisch bis an die Kante (4, 2) der Glasscheibe heranreicht, während der Abschnitt, der als Verbindungslinie (9) zum Abschlussfeld (8) des elektronischen Schaltkreises dient, entlang einer im wesentlichen senkrechten Kante (10), jedoch im Abstand von dieser angeordnet ist, und dass in dem Bereich, den die Verbindungslinie von der betreffenden Kante trennt, Schaltlinien und Kontaktfelder (12, 13; 36, 37; 44; 51 bis 55; 64 bis 67) angeordnet sind.

2. Glasscheibe nach Anspruch 1, dadurch gekennzeichnet, dass der Annäherungsfühler (5, 33), die Verbindungslinie (9), die Schaltlinien (12, 13; 36, 37; 44; 51 bis 55; 64 bis 67) und ihre Kontaktfelder und das Abschlussfeld (8) aus einem elektrisch leitenden eingebrannten Email bestehen, das in Form einer keramischen Paste mit Hilfe des Siebdruckverfahrens aufgebracht und bei einer Temperatur in der Grössenordnung von 600°C in einem einzigen Verfahrensschritt eingebrannt wird.

3. Glasscheibe nach einem der Ansprüche 1 und 2, dadurch gekennzeichnet, dass der Annäherungsfühler die Form eines eine geschlossene Schleife bildenden Doppelleiters (61) aufweist.

4. Glasscheibe nach einem der Ansprüche 2 und 3, dadurch gekennzeichnet, dass die elektrischen Leitstreifen mit einer elektrisch isolierenden Schutzschicht (32, 46, 68) aus einem eingebrannten, mit dem ersten Email verträglichen Email abgedeckt sind.

5. Glasscheibe nach einem der Ansprüche 1 bis 4, gekennzeichnet durch eine Detektorschaltung, die aus einem kompakten Bauelement (30) besteht, das auf derselben Oberfläche angeordnet ist.

**Fig. 1**

**Fig. 2**

7

Fig. 3

Fig. 4

Fig. 6

Fig. 5

**Fig. 8**

0 061 409